# DEMANDE DE BREVET EUROPEEN

(11) **EP 3 216 651 A1**
(43) Date de publication de la demande: **13.09.2017**
(21) Numéro de dépôt: 17158889.0
(22) Date de dépôt: 02.03.2017
(51) Int. Cl.: B60Q 1/08, F21S 8/10, H01L 27/146, H01L 27/15, B60Q 1/14, G06T 7/00, H05B 33/08, F21Y 105/10

(54) **PROJECTEUR ANTI-EBLOUISSEMENT**

(30) Priorité: 02.03.2016 FR 1651781
(71) Demandeur: Valeo Vision, 93012 Bobigny Cedex (FR)
(72) Inventeur: LESAFFRE, Olivier-Sébastien, 93500 Pantin (FR); DE LAMBERTERIE, Antoine, 75019 Paris (FR); CANONNE, Thomas, 78300 Poissy (FR); THIN, Guillaume, 78280 Guyancourt (FR); MBATA, Samira, 93300 Aubervilliers (FR)

(57) **Abrégé**

Il est proposé un projecteur pour véhicule comprenant au moins une diode électroluminescente, dans lequel ladite au moins une diode électroluminescente est configurée pour fonctionner comme un détecteur d'une source lumineuse.

## Description

### DOMAINE DE L'INVENTION

La présente invention concerne le domaine des projecteurs pour véhicules, et en particulier celui des projecteurs permettant d'atténuer l'éblouissement que subit un conducteur.

### ARRIERE-PLAN

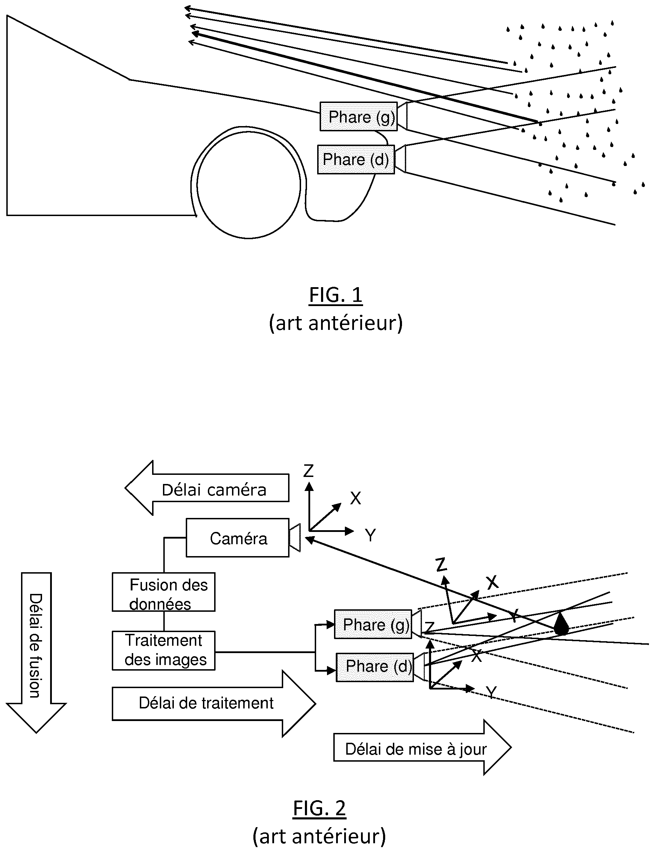

Il est connu de longue date que le faisceau lumineux émis par un projecteur tel qu'un feu de croisement (« low beam » en anglais) ou un feu de route (« high beam » en anglais) peut éblouir le conducteur car le faisceau lumineux peut se réfléchir sur des éléments de la scène qui est éclairée par le projecteur. La FIG. 1 illustre ce problème. Parmi les éléments éclairés de la scène qui sont susceptibles de réfléchir la lumière, on trouve notamment des éléments naturels tels que les gouttes de pluie ou les flocons de neige. Ainsi, en situation d'intempérie, la visibilité du conducteur n'est pas satisfaisante à cause des multiples réflexions de la lumière émise par son véhicule.

Un dispositif connu contre ce problème est illustré sur la FIG. 2. Le dispositif comporte une caméra qui détecte les gouttes de pluie, et le faisceau lumineux des deux phares est modifié afin que les gouttes détectées ne soient plus illuminées. Toutefois, cette solution n'est pas efficace car les moyens qu'elle met en oeuvre ne permettent pas une analyse dans un temps suffisamment court de sorte que les corrections apportées aux projecteurs ne sont plus valables.

Le but de la présente invention est de fournir une solution palliant ces inconvénients. Plus particulièrement, l'invention vise à fournir un dispositif et un procédé de détection et d'occlusion d'éléments réfléchissants d'une scène éclairée par des projecteurs qui soit simple et efficace, et qui permette de corriger l'éclairage de la scène rapidement.

### RESUME DE L'INVENTION

A cette fin, la présente invention propose un projecteur pour véhicule qui comprend au moins une diode électroluminescente, ladite au moins une des diodes étant configurée pour fonctionner comme un détecteur d'une source lumineuse. C'est ainsi que les propriétés physiques des diodes sont exploitées non seulement pour émettre de la lumière, mais également pour transformer une lumière en courant électrique (ou en tension). Ainsi, la détection des gouttes ne repose plus sur l'usage d'une caméra, mais utilise au moins une diode du projecteur.

Le projecteur peut comprendre également :
- être adapté pour être couplé à une unité de contrôle qui est configurée pour faire fonctionner alternativement ladite au moins une au moins une diode électroluminescente comme un détecteur d'une source lumineuse et comme un émetteur de lumière ;
- l'unité de contrôle est en outre configurée pour transmettre un signal de synchronisation indiquant si ladite au moins une diode électroluminescente fonctionne comme un émetteur de lumière ou comme un détecteur d'une source lumineuse ;
- l'unité de contrôle est en outre configurée pour alterner le fonctionnement de ladite au moins une diode électroluminescente sur réception du signal de synchronisation ;
- une première mémoire qui enregistre si ladite au moins une diode électroluminescente a détecté une source lumineuse lors du dernier fonctionnement de ladite au moins une diode électroluminescente comme un détecteur d'une source lumineuse ; et une deuxième mémoire qui enregistre si ladite au moins une diode électroluminescente a détecté une source lumineuse lors de l'avant-dernier fonctionnement de ladite au moins une diode électroluminescente comme un détecteur d'une source lumineuse ;
- une unité de calcul qui calcule la vitesse de déplacement et la direction du déplacement d'une source lumineuse détectée par comparaison des enregistrements de la première mémoire et de la deuxième mémoire ;
- une matrice de diode comprend ladite au moins une diode électroluminescente ;
- une matrice de miroirs réfléchit une source lumineuse émise ou détectée par ladite au moins une diode électroluminescente de la matrice.
- toutes les diodes de la matrice fonctionnent alternativement comme des émetteurs de lumière et comme des détecteurs d'une ou plusieurs sources lumineuses ;
- une matrice de miroirs réfléchit une source lumineuse émise ou détectée par ladite au moins une diode électroluminescente, les miroirs de la matrice étant configurés pour qu'un seul miroir puisse réfléchir vers la ladite au moins une diode électroluminescente une source lumineuse.

La présente invention propose également un dispositif d'éclairage qui comprend au moins deux projecteurs selon l'invention.

Le dispositif peut également comprendre :
- ladite au moins une diode d'un premier projecteur est configurée pour fonctionner comme (i) un émetteur de lumière lorsque ladite au moins une diode d'un deuxième projecteur est configurée comme un détecteur d'une source lumineuse et comme (ii) un détecteur d'une source lumineuse lorsque ladite au moins une diode du deuxième projecteur est configurée comme un émetteur de lumière ;
- chaque projecteur comprend une unité de contrôle, les unités de contrôle étant connectées entre elles afin que le signal de synchronisation transmis par l'unité de contrôle d'un des projecteurs soit reçu par l'unité de contrôle de l'autre projecteur ;
- au moins deux projecteurs sont couplés à une unité de contrôle qui transmet le signal de synchronisation aux projecteurs ;
- chaque projecteur comprend une unité de calcul ;
- lesdits au moins deux projecteurs sont en outre configurés pour simultanément émettre de la lumière ;

Il est également proposé un procédé de détection et d'occlusion de sources lumineuses ; le procédé est réalisé avec le dispositif d'éclairage susmentionné. Le procédé comprend les étapes consistant à :
- envoyer un premier signal de synchronisation ;
- suite à l'envoi du premier signal de synchronisation :
   -- émettre de la lumière avec ladite au moins une diode du deuxième projecteur ; et
   -- faire fonctionner ladite au moins une diode du premier projecteur comme détecteur d'une source lumineuse;
- enregistrer dans la première mémoire du premier projecteur si ladite au moins une diode du premier projecteur a détecté une source lumineuse ;
- envoyer un deuxième signal de synchronisation ;
- suite à l'envoi du deuxième signal de synchronisation :
   -- émettre de la lumière avec ladite au moins une diode du premier projecteur; et
   -- faire fonctionner ladite au moins une diode du deuxième projecteur comme détecteur d'une source lumineuse;
- enregistrer dans la première mémoire du deuxième projecteur si ladite au moins une diode du deuxième projecteur a détecté une source lumineuse.

Le procédé peut en outre comprendre répéter les étapes du procédé dans lesquelles les étapes d'enregistrement sont réalisées sur la deuxième mémoire du premier ou deuxième projecteur, et peut en outre comprendre les étapes consistant à :
- suite à l'enregistrement dans la deuxième mémoire du premier projecteur, calculer par l'unité de calcul la vitesse et la direction de déplacement de la source lumineuse détectée par le premier projecteur et déterminer les diodes de la matrice du premier projecteur pouvant émettre de la lumière en fonction du calcul ;
- suite à l'enregistrement dans la deuxième mémoire du deuxième projecteur, calculer par l'unité de calcul la vitesse et la direction de déplacement de la source lumineuse détectée par le deuxième projecteur et déterminer les diodes de la matrice du deuxième projecteur pouvant émettre de la lumière en fonction du calcul ;
- envoyer un troisième signal de synchronisation ;
- suite à l'envoi du troisième signal de synchronisation, configurer le premier et le deuxième projecteur pour qu'ils émettent simultanément de la lumière, seules étant activées les diodes déterminées comme pouvant émettre de la lumière.

Il est également proposé un procédé de détection et d'occlusion de sources lumineuses avec le dispositif d'éclairage susmentionné dans lequel les projecteurs comprennent chacun une unité de calcul. Le procédé comprend l'envoi d'un premier signal de synchronisation d'un premier projecteur (dit projecteur maître) selon l'invention à un deuxième projecteur (dit projecteur esclave) selon l'invention. Suite à la réception du premier signal de synchronisation par le deuxième projecteur, ladite au moins une diode de la matrice du deuxième projecteur émet de la lumière, ladite au moins une diode du premier projecteur fonctionnant comme détecteur d'une source lumineuse suite à l'émission du premier signal de synchronisation. Le premier projecteur enregistre dans sa première mémoire si ladite au moins une diode du premier projecteur a détecté une source lumineuse. Un deuxième signal de synchronisation est envoyé par le premier projecteur au deuxième projecteur. Ladite au moins une diode du premier projecteur émet de la lumière suite à l'émission du deuxième signal de synchronisation, ladite au moins une diode du deuxième projecteur fonctionnant comme détecteur d'une source lumineuse suite à la réception du deuxième signal. Le deuxième projecteur enregistre dans sa première mémoire si ladite au moins une diode du deuxième projecteur a détecté une source lumineuse.

### BREVE DESCRIPTION DES FIGURES

D'autres caractéristiques et avantages de l'invention apparaîtront à la lecture de la description détaillée qui suit de l'invention, donnée à titre d'exemple et en référence aux dessins annexés, dans lesquels :
- Les Figures 1 et 2 représentent des exemples de systèmes de projecteurs connus de l'art antérieur ;
- La Figure 3a représente une vue schématique d'un exemple de projecteur selon l'invention ;
- La Figure 3b représente une vue schématique d'un autre exemple de projecteur selon l'invention ;
- La Figure 3c représente une vue schématique d'un autre exemple de projecteur selon l'invention ;
- La Figure 4 représente un exemple du fonctionnement d'un dispositif selon l'invention ;
- La Figure 5 représente un exemple de matrice de diodes pouvant être utilisé avec un projecteur selon l'invention ;
- La Figure 6 représente une vue détaillée d'une sous-matrice de la Figure 5 ;
- La Figure 7 représente un exemple d'unité de contrôle d'un projecteur selon l'invention ;
- La Figure 8 représente un exemple de schéma d'opérations d'un dispositif utilisant le procédé de détection et d'occlusion selon l'invention ;
- Les Figures 9a, 9b, et 9c montrent des exemples de matrices de diodes ;
- Les Figures 10a et 10b montrent des exemples de configuration d'un dispositif selon l'invention.

### DESCRIPTION DETAILLEE

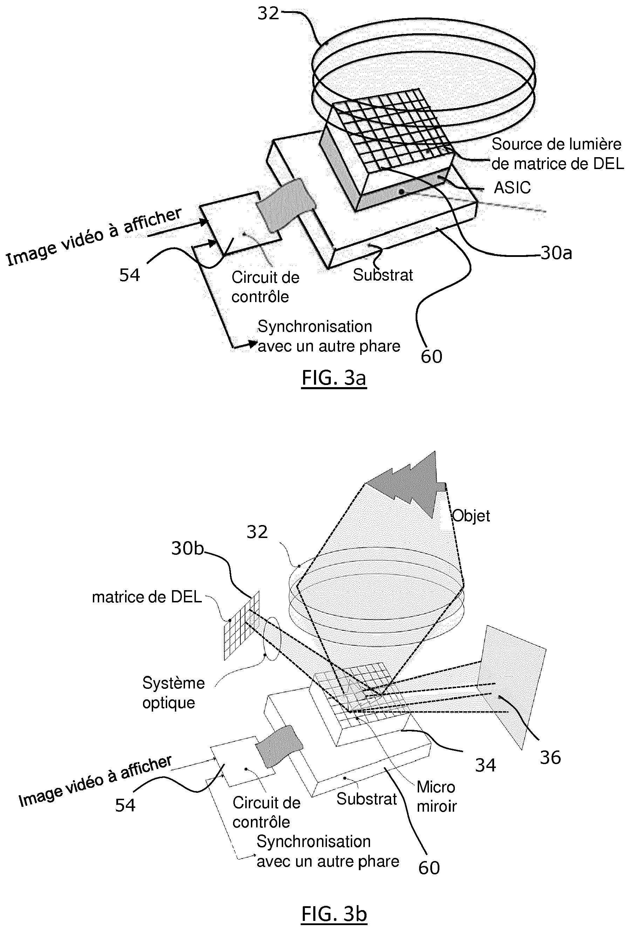

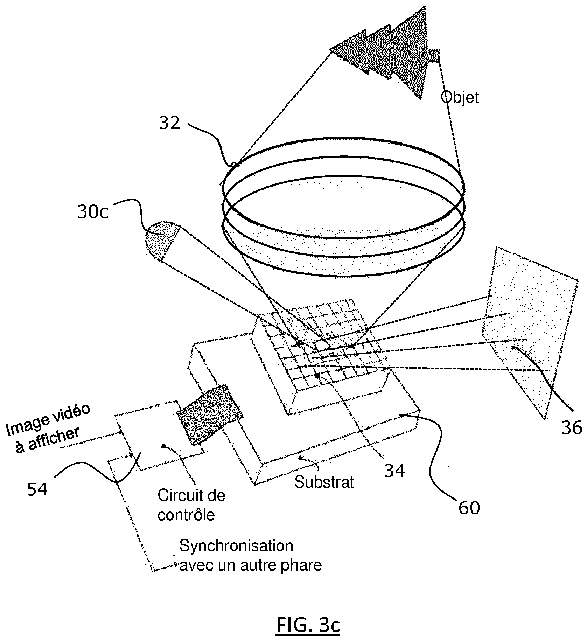

Se référant aux Figures 3a, 3b, 3c, trois exemples de projecteur selon l'invention sont décrits. Le projecteur peut être un projecteur pour véhicule terrestre, par exemple un phare d'automobile. Le projecteur peut être indifféremment un projecteur gauche ou un projecteur droit d'une voiture ; par exemple un projecteur avant gauche ou avant droit (le problème de réflexion de la lumière étant particulièrement gênant dans cette configuration). Le projecteur comprend au moins une diode électroluminescente (DEL, ou « LED » en anglais). Les termes DEL et diode(s) ont la même signification par la suite.

Selon l'exemple de la figure 3a, le projecteur comprend une matrice 30a de DEL dans laquelle au moins une des DEL de la matrice est configurée pour fonctionner comme un détecteur d'une source lumineuse. La source lumineuse détectée est une source lumineuse entrant dans le projecteur; autrement dit la source lumineuse détectée par le projecteur est située à l'extérieur du projecteur. Le terme matrice de DEL (aussi connu sous le terme « grille de DEL ») fait référence à un réseau de plusieurs DEL qui sont disposées selon un motif qui peut être régulier. Ces réseaux permettent de remplacer les lampes à incandescence ou fluorescence des appareils d'éclairage, comme de même pour les feux de signalisation, de stop, clignotants et dispositifs de visualisation de sécurité pour véhicules automobiles.

Selon l'exemple de la Figure 3b, le projecteur comprend, en plus de la matrice de DEL 30b, une matrice de miroirs 34 qui réfléchissent la lumière émise par les DEL de la matrice 30b ou bien qui réfléchissent la lumière émise par une source lumineuse (externe au projecteur) vers au moins une diode électroluminescente de la matrice. Le terme matrice de miroirs (aussi connu sous le terme de matrice de micro-miroirs, traduction littérale du terme anglais « Digital Micromirror Device » ou de son acronyme DMD) fait référence à microsystème électromécanique permettant la projection d'une source lumineuse (pixélisée ou pas) sur des micro-miroirs. Chaque miroir peut prendre deux positions : il peut s'incliner suivant le même axe de façon à réfléchir la lumière soit vers un système de lentilles 32 soit vers une surface la matrice de DEL 30b. Chaque micro-miroir bascule (ou commute) selon deux positions différentes dites « on » ou « off ». Chaque DEL de la matrice est associée à une partie de la matrice de miroir.

Toujours en référence à la figure 3b, le nombre de DEL de la matrice 30b et le nombre de miroirs de la matrice 34 peuvent être égaux de sorte qu'un seul ou plusieurs miroirs réfléchissent la lumière émise ou reçue par une seule DEL de la matrice. Il peut donc s'agir d'une association surjective entre une DEL et plusieurs miroirs. Le nombre de DEL de la matrice 30b peut être inférieur au nombre de miroirs de la matrice 34 de sorte que la lumière émise par une DEL est réfléchie par un ou plusieurs miroirs et la lumière reçue par une DEL (configurée pour fonctionner comme un détecteur d'une source lumineuse) est réfléchie par plusieurs miroirs. Dans ce cas de figure, la relation entre les DEL et les miroirs est telle que N miroirs de la matrice forment un groupe de miroirs qui sont associés avec une seule DEL ; de préférence, les miroirs du groupe ont tous une position qui est identique (tous « on » ou bien tous « off »). Enfin, le nombre de DEL de la matrice 30b peut être supérieur au nombre de miroirs de la matrice 34 de sorte que la lumière émise par plusieurs DEL est réfléchie par un seul miroir et la lumière reçue par plusieurs DEL (configurées pour fonctionner comme des détecteurs d'une source lumineuse) est réfléchie par un miroir. La relation entre les DEL et les miroirs est telle que N DEL de la matrice forment un groupe de DEL et sont associés avec un seul miroir ; de préférence, les DEL du groupe sont, soit toutes configurées pour fonctionner comme des détecteurs de sources lumineuses, soit toutes configurées pour fonctionner comme des émettrices de lumière.

Dans l'exemple de la Figure 3b, le projecteur peut comprendre en outre une surface absorbante 36 qui limite les réflexions de la source lumineuse entrante dans le projecteur par les miroirs qui ne sont pas positionnés pour réfléchir la lumière vers la matrice de DEL 30b.

Dans l'exemple de la figure 3c, le projecteur comprend une DEL 30c, une matrice de miroirs 34 qui réfléchissent la lumière émise par la DEL 30c ou bien qui réfléchissent vers par la DEL 30c une source lumineuse entrant dans le projecteur. Lorsque la DEL émet de la lumière, les miroirs de la matrice sont positionnés pour que la lumière émise soit envoyée vers le système de lentilles 32. Ainsi, les miroirs peuvent être positionnés pour former et renvoyer une image vers le système de lentilles 32.

Toujours dans l'exemple de la figure 3c, lorsque la DEL est configurée pour fonctionner comme un détecteur d'une source lumineuse, les miroirs de la matrice sont configurés pour qu'un seul miroir de la matrice 34 puisse réfléchir la source lumineuse devant être détectée par la DEL 30c. Ainsi, lorsque la DEL est configurée pour fonctionner comme un détecteur d'une source lumineuse, chaque miroir de la matrice, un après l'autre, est mis dans la position permettant de renvoyer la lumière d'une source lumineuse vers la DEL. Les autres miroirs de la matrice (c'est-à-dire tous les miroirs hormis celui qui est en position permettant de renvoyer la lumière d'une source lumineuse vers la DEL) sont dans une position dans laquelle la lumière de la source lumineuse n'est pas réfléchie vers la DEL. Le projecteur peut comprendre en outre une surface absorbante 36 qui limite les réflexions de la source lumineuse entrante dans le projecteur par les miroirs qui ne sont pas positionnés pour réfléchir la lumière vers la DEL 30c.

L'exemple de la figure 3a est le plus simple à implémenter parmi les trois exemples car la matrice de DEL éclaire et détecte directement. L'exemple de la figure 3b permet notamment d'utiliser une matrice de DEL ayant un nombre de DEL inférieur à celle de la figure 3a tout en conservant une granularité dans la détection semblable à celle de la figure 3a ; la gestion de la matrice de DEL est simplifiée et l'acquisition d'une image de la scène (et des sources lumineuses de la scène) est plus rapide. L'exemple de la figure 3c permet d'utiliser une seule DEL comme émetteur de lumière/détecteur de lumière, ce qui facilite la gestion de la DEL (un seul ASIC requis par exemple) et réduit les coûts de fabrication du projecteur.

Dans la présente invention, au moins une DEL sert de source lumineuse, c'est-à-dire qu'une ou plusieurs DEL émettent de la lumière (des photons) sous l'action d'une tension électrique appliquée à la jonction P-N de la (des)DEL. Au moins une DEL comprise dans le projecteur sert également de détecteur d'une source lumineuse, c'est-à-dire que des photons émis par une source lumineuse sont captés au niveau d'une ou plusieurs DEL de la matrice qui génère(nt) un courant électrique en conséquent. Les propriétés physiques des DEL sont donc utilisées (alternativement) pour émettre le la lumière et pour détecter de la lumière émise par des éléments d'une scène. La scène est un espace qui doit être éclairé par les projecteurs, c'est-à-dire au moins une partie de l'espace qui doit être rendu visible par exemple à un conducteur d'un véhicule. On comprend que la scène peut être amenée à évoluer, par exemple lorsque le véhicule est en mouvement. La lumière émise par un élément de la scène constitue une source lumineuse; par exemple une goutte de pluie est un élément de la scène qui réfléchit de la lumière et constitue donc une source lumineuse. Les sources lumineuses de la scène sont donc externes au projecteur.

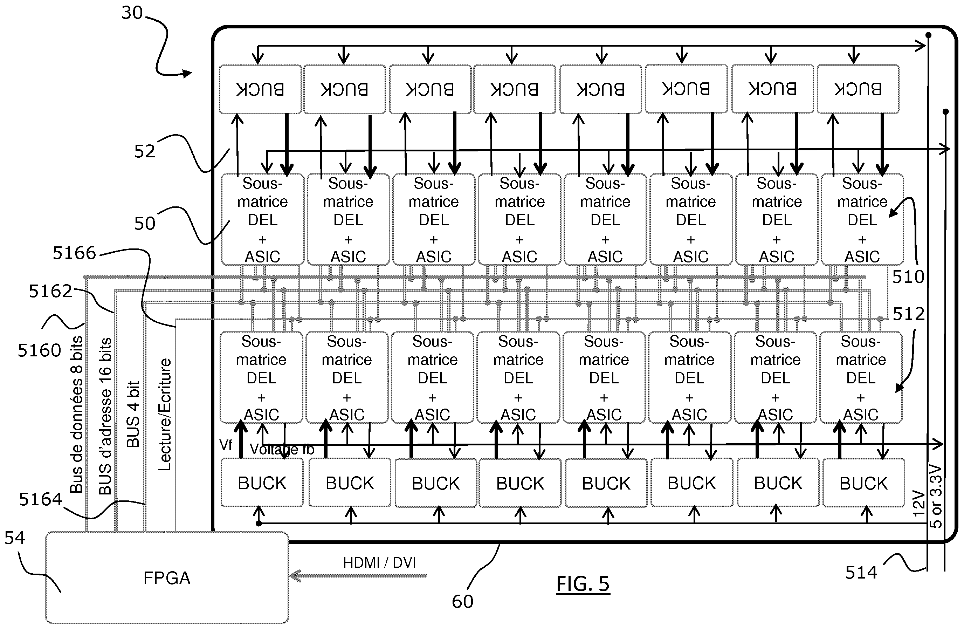

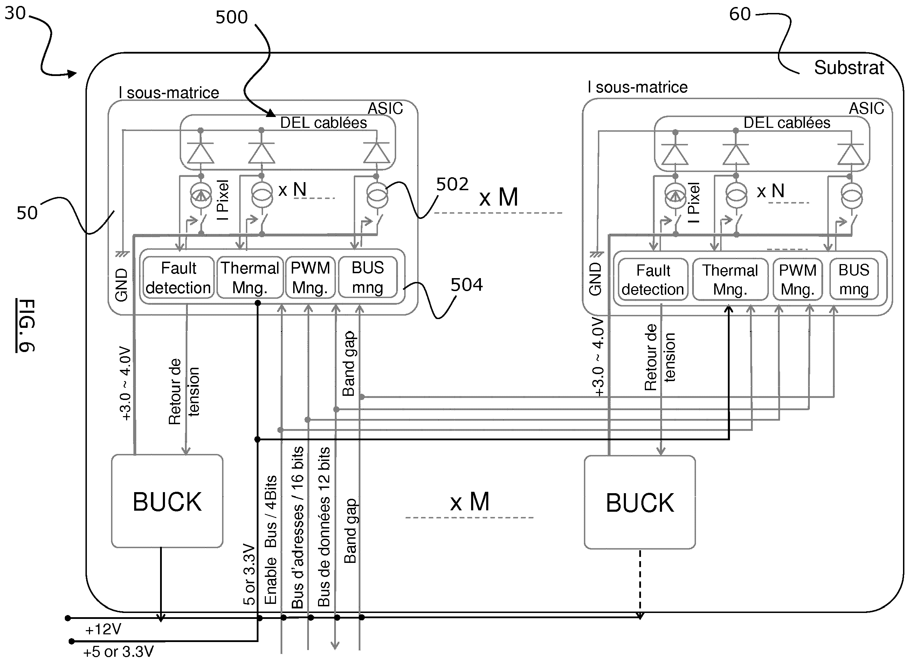

Les Figures 5 et 6 montrent un exemple de configuration d'une matrice de LED qui peut être utilisée avec les exemples des Figures 3a et 3b.

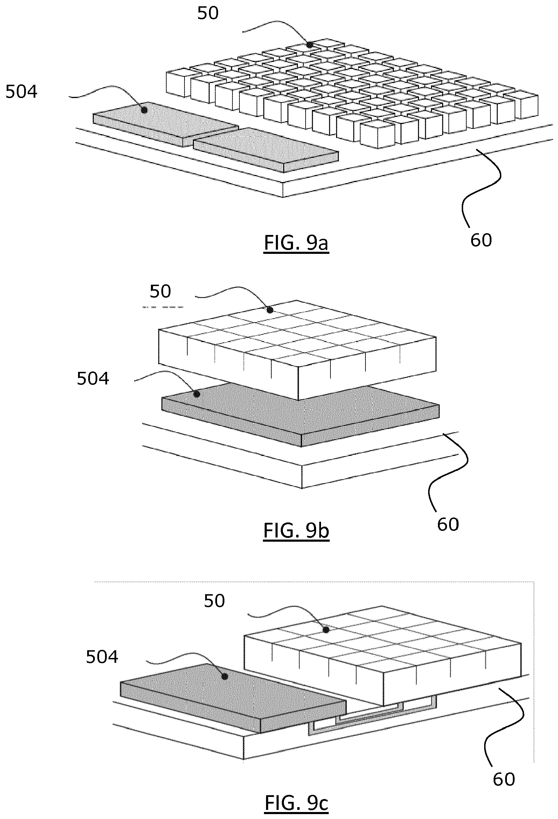

Sur l'exemple de la Figure 5, la matrice est composée d'un ensemble de réseau de DEL (« LED Sub Matrix » en anglais) qui sont alignées sur deux lignes 510, 512 de sous-matrices 50 et forment ainsi une grille de sous-matrices 50 disposée sur un support 60 (ou encore nommé substrat 60). Chaque sous-matrice 50 comporte un ASIC (acronyme de l'anglais « application-specific integrated circuit », littéralement « circuit intégré propre à une application ») qui est configuré pour gérer les LED de chaque sous-matrice. La gestion comporte notamment la configuration d'une ou plusieurs DEL de la sous-matrice pour émettre de la lumière ou encore comme détecteur de lumière. On comprend qu'un ASIC peut gérer une ou plusieurs sous-matrices, comme cela est discuté en référence à la Figure 9a.

La gestion centralisée des sous-matrices est réalisée à l'aide d'une unité de contrôle 54 qui peut être de type FPGA (acronyme de l'anglais « field-programmable gâte array», littéralement « réseau de portes programmables in situ ») qui communique avec les ASIC de chaque sous-matrice à l'aide des bus 1560, 1562, 1564, 1566 qui fournissent respectivement un bus 1560 de transfert/réception de données vers/de l'ASIC d'une sous-matrice, un bus 1562 d'adressage afin de sélectionner l'ASIC avec lequel communiquer, un bus 1564 pour déclencher un état d'une sous-matrice et un bus 1566 pour lire/écrire sur un ASIC d'une sous-matrice. L'unité de contrôle peut être connectée à une source vidéo (par exemple une caméra) via une interface vidéo spécialisée ; par exemple une interface HDMI (acronyme anglais de « High Definition Multimedia Interface », littéralement « Interface Multimédia Haute Définition ») ou encore une interface DVI (acronyme anglais de « Digital Visual Interface », littéralement « interface vidéo numérique »). Cela permet à l'unité de contrôle de reconfigurer la matrice de DEL en fonction d'un signal vidéo reçu. La source vidéo peut également être fournie par un système ADAS (acronyme de l'anglais "Advanced Driver Assistance Systems", littéralement Advanced Driver Assistance Systems) comme connu dans l'art.

Chaque sous-matrice est alimentée électriquement par un convertisseur de tension 52 qui convertit la tension électrique de la ligne d'alimentation 514 en une tension électrique plus faible. Le convertisseur de tension peut être de type BUCK. Le convertisseur de tension permet d'alimenter l'ASIC de chaque sous-matrice de LED. Chaque sous-matrice est également alimentée par une deuxième ligne d'alimentation 512 qui présente une tension différente de celle de la première ligne ; par exemple, la deuxième ligne fournit le courant nécessaire aux DEL de chaque sous-matrice pour qu'elle puisse éclairer la scène (c'est-à-dire émettre de la lumière).

La Figure 6 montre un exemple détaillé de sous-matrices 50. Chaque sous-matrice comporte plusieurs LED qui sont montées en parallèle, et chaque LED est individuellement alimentée par une source de courant 502. La gestion des LED de la sous-matrice est assurée par l'ASIC 504 qui comprend notamment des fonctions de gestion des bus, de l'alimentation électrique, de la température, et de détection de problèmes des DEL.

On comprendra que les exemples des Figures 5 et 6 peuvent être modifiés dépendant des évolutions technologiques des matrices de DEL ou encore dépendant de choix technologiques, comme illustré sur les Figures 9a, 9b, et 9c. Par exemple, la matrice peut ne pas être constituée de sous-matrices et ne comprendre qu'une seule et unique matrice de DEL dans laquelle chaque DEL peut servir alternativement de capteur de lumière et d'émetteur de lumière.

Les Figures 9a, 9b, et 9c montrent d'autres exemples de matrices de DEL. La Figure 9a montre un exemple semblable à celui discuté en référence à la Figure 5 à la différence qu'un ASIC gère plusieurs sous-matrices. On comprendra qu'un ASIC pourrait également gérer plusieurs DEL indépendantes assemblées pour constituer une matrice de DEL. La Figure 9b montre un exemple dans lequel la matrice ne comprend pas de sous-matrices mais une unique matrice. Toujours dans cet exemple, un ASIC (contrôlant la matrice de DEL) est situé entre un support 60 et la matrice de DEL. La Figure 9c montre un exemple semblable à celui de la Figure 9b, mais dans cet exemple l'ASIC et la matrice de DEL sont tous deux situés directement sur le support 60.

De retour sur la Figure 3a, la matrice de DEL est disposée sur l'ASIC de sorte que les matériaux semi-conducteurs sont disposés sur des plages de connexion agencées, selon une configuration préalablement choisie, situées sur un élément support isolant qui comporte l'ASIC qui commande le réseau de jonctions P et N des DEL.

Sur la Figure 3b, la matrice de DEL 30b est positionnée de sorte à éclairer la matrice de miroirs 34 qui est elle-même positionnée sur le support 60.

Sur la Figure 3b, la DEL 30c est positionnée de sorte à éclairer la matrice de miroirs 34 qui est elle-même positionnée sur le support 60.

Le projecteur des Figures 3a, 3b, 3c peut être adapté pour être couplé avec une unité de contrôle qui configure le fonctionnement de la ou des DEL. L'unité de contrôle peut être par exemple le FPGA 54 présenté avec les Figures 5 et 6. L'unité de contrôle peut configurer une ou plusieurs DEL pour qu'elles émettent de la lumière, c'est-à-dire qu'elle contrôle individuellement l'alimentation électrique de chaque diode. Ce contrôle est effectué comme connu dans l'art ; par exemple le FPGA envoie via un ou plusieurs BUS un ordre à (ou aux) l'ASIC concerné(s) qui va (vont) à son (leur) tour mettre sous tension les DEL devant émettre de la lumière. L'unité de contrôle peut également recevoir l'information qu'une ou plusieurs DEL ont détecté une source lumineuse : l'unité de contrôle peut lire le courant électrique généré par une DEL qui a détecté une source lumineuse. En pratique, l'ASIC de la sous-matrice auquel la DEL détectant une source lumineuse est rattachée envoie un message à l'unité de contrôle via un ou plusieurs BUS et l'unité de contrôle est configurée pour identifier la DEL. L'unité de contrôle peut donc commander individuellement le fonctionnement de chaque DEL (alternativement comme émetteur de lumière ou bien comme détecteur de source lumineuse), et elle est également configurée pour déterminer quelle DEL a détecté une source lumineuse. On comprend que le passage d'un fonctionnement à l'autre peut être réalisé soit à partir d'une DEL qui émet de la lumière ou bien soit à partir d'une DEL qui sert de détecteur.

L'unité de contrôle est couplée au projecteur à l'aide de moyens conventionnels (par exemple un circuit électrique). Le projecteur selon l'invention peut comprendre l'unité de contrôle.

L'unité de contrôle peut également transmettre un signal de synchronisation qui sert à synchroniser le fonctionnement du premier projecteur avec celui d'un deuxième projecteur selon l'invention. Le signal de synchronisation indique quel est le mode de fonctionnement d'une ou plusieurs DEL que commande l'unité de contrôle. Le signal de synchronisation est typiquement une impulsion de synchronisation; par exemple un signal électrique rectangulaire d'une hauteur et largeur prédéterminées, ou encore une commande sur un bus de communication tel que CAN (Controller Area Network), Ethernet, CAN FD (flexible Data rate), FlexRay. Le signal de synchronisation est transporté de l'unité de contrôle vers un deuxième projecteur en utilisant un BUS (qui peut être dédié à cette fonction ou non), étant entendu que le BUS peut être, mais n'est pas limité à, un lien physique (fil électrique par exemple) ou encore un lien sans fil (Bluetooth^{®} par exemple). En pratique, le BUS peut être un lien physique, ce qui fournit une meilleure vitesse de propagation et une meilleure garantie de bonne transmission du signal de synchronisation.

L'unité de contrôle peut également modifier le fonctionnement d'une ou plusieurs DEL sur réception d'un signal de synchronisation. Ainsi, sur réception d'un signal externe, l'unité de contrôle peut déclencher l'émission de lumière par une ou plusieurs DEL, ou encore déclencher le fonctionnement d'une ou plusieurs DEL comme détecteur de sources lumineuses. Le signal de synchronisation reçu est transporté à l'aide de moyens semblables à ceux utilisés pour émettre le signal de synchronisation.

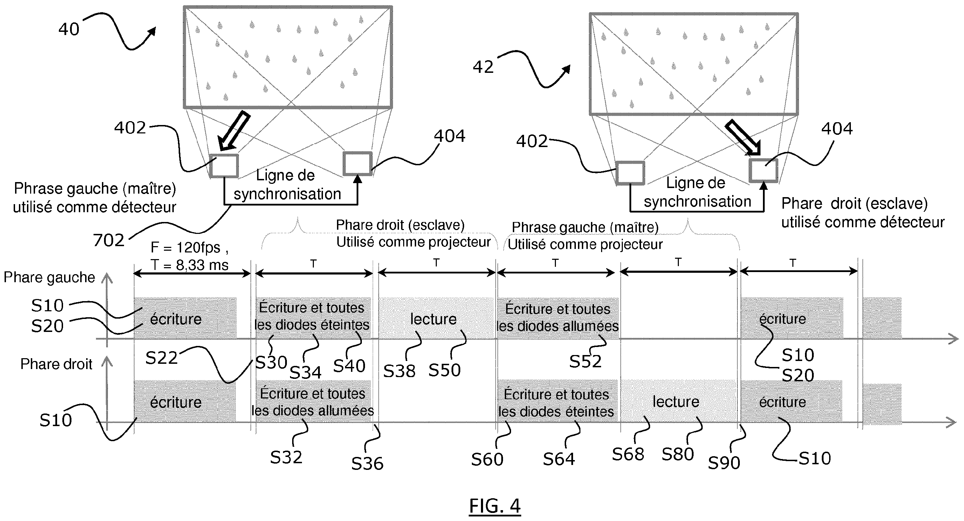

L'unité de contrôle peut être configurée pour émettre uniquement un signal de synchronisation, ou bien recevoir uniquement un signal de synchronisation, ou encore émettre et recevoir un signal de synchronisation. En pratique, l'unité de contrôle est configurée pour émettre et recevoir un signal de synchronisation car cela facilite l'assemblage et la configuration d'un dispositif utilisant au moins deux projecteurs selon l'invention, comme par exemple décrit plus tard en référence à la Figure 4.

L'émission et/ou la réception d'un signal de synchronisation peut(vent) être gérée(s) par une sous-unité de synchronisation elle-même gérée par l'unité de contrôle.

L'unité de contrôle peut également comprendre une entrée vidéo lui permettant de reconfigurer la matrice de DEL des figures 3a et 3b ou bien la matrice de miroirs des figures 3b et 3c en fonction d'un signal vidéo reçu. Par exemple, si une caméra détecte (elle filme) qu'un véhicule vient à la rencontre du véhicule disposant de projecteurs selon l'invention, l'unité de contrôle peut commander l'extinction d'une ou plusieurs DEL de la matrice de la figure 3a et 3b afin de ne pas éclairer le véhicule à l'approche, ou encore ne pas éclairer une partie du véhicule à l'approche (le pare-brise par exemple) ; ou encore, l'unité de contrôle peut commander la position d'un ou plusieurs miroirs de la figure 3b et 3C afin qu'il ne réfléchissent pas la lumière émise par la matrice de DEL 30b ou la DEL 30c en direction du véhicule à l'approche, ou encore d'une partie du véhicule à l'approche (le pare-brise par exemple). L'occlusion d'une ou plusieurs DEL ou la position d'un ou plusieurs miroirs suite à la réception d'un signal vidéo peut être réalisée en mettant en oeuvre des moyens connus d'occlusion des sources lumineuse du projecteur ou de gestion des positions des miroirs. L'unité de contrôle peut en outre être également utilisée pour envoyer des informations à l'intention d'autres usagers de la route, par exemple pour les avertir de la présence d'un passage piéton, d'un danger,...

Le projecteur des Figures 3a, 3b, et 3c peut également comprendre un système de lentilles 32 qui permet de modifier le rayonnement des DEL. Les lentilles de DEL sont fréquemment utilisées pour augmenter l'angle de la lumière et par conséquent augmenter le champ de vue éclairé (acronyme anglais « FoV » pour Field of View).

L'unité de contrôle des Figures 3a et 3b peut disposer d'au moins une mémoire lui permettant d'enregistrer quelle DEL a détecté une source lumineuse. La mémoire peut stocker un tableau dans lequel chaque case du tableau est associée avec une seule DEL de la matrice, et la valeur stockée dans la case indique si la DEL a détecté une source lumineuse (la valeur est par exemple « 1 ») ou n'a pas détecté une source lumineuse (la valeur est par exemple « 0 »). D'autres manières d'enregistrer une source lumineuse détectée sont envisageables. Par exemple, la mémoire peut être capable de stocker des informations supplémentaires autres que la simple détection d'une source lumineuse. Comme autre exemple, la mémoire peut être capable de stocker une valeur du flux lumineux détecté (le courant généré par une DEL varie proportionnellement en fonction de la quantité de lumière détectée), ou encore stocker le type d'objet lumineux qui a été détecté (par exemple une goutte de pluie, une flaque, un panneau de signalisation routière...).

L'unité de contrôle de la Figure 3c peut disposer d'au moins une mémoire lui permettant d'enregistrer quelles sont les miroirs pour lesquels, lorsqu'ils ont été en position permettant de réfléchir la lumière vers la DEL, la DEL 30c a détecté une source lumineuse. La mémoire peut stocker un tableau dans lequel chaque case du tableau est associée avec un seul miroir de la matrice, et la valeur stockée dans la case indique si la DEL a détecté une source lumineuse lorsque le miroir était en position permettant de réfléchir la source lumineuse vers la DEL. On comprendra que les exemples sur la manière de stocker discutés en référence aux Figures 3a et 3b peuvent être adaptés à l'unité de contrôle de la Figure 3c. L'unité de contrôle peut comporter deux mémoires. La première mémoire enregistre (ou encore elle mémorise) quelles DEL de la matrice ont détecté une source lumineuse ou quels miroirs ont réfléchi une source lumineuse sur la DEL lors du dernier fonctionnement d'une ou plusieurs DEL en tant que détecteur d'une source lumineuse, relativement à l'instant de l'enregistrement. La deuxième mémoire enregistre (ou encore elle mémorise) quelles DEL de la matrice ont détecté une source lumineuse ou quels miroirs ont réfléchi une source lumineuse sur la DEL lors de leur avant-dernier fonctionnement en tant que détecteur d'une source lumineuse, relativement à l'instant de l'enregistrement. L'avant-dernier fonctionnement d'une ou plusieurs DEL en tant que détecteur d'une source lumineuse s'entend comme celui qui a été suivi par un fonctionnement en tant que qu'émetteur de lumière et détecteur de source lumineuse. La première mémoire comprend donc les résultats de la détection les plus récents, et la deuxième mémoire comprend les résultats de la détection précédemment aux plus récents. Lorsque de nouveaux résultats de détection sont lus (on peut également dire acquis) par l'unité de contrôle, les deux mémoires peuvent être gérées comme suit : les résultats stockées sur la première mémoire sont transmis à la deuxième mémoire qui remplace les anciens résultats par les résultats qui lui ont été transmis; après cela, les nouveaux résultats de la détection sont enregistrés sur la première mémoire.

Alternativement, les nouveaux résultats de la détection viennent écraser les résultats inscrits dans la mémoire qui stocke les résultats les plus anciens. On comprend que dans cette alternative la première mémoire ne se définit plus comme celle qui comprend les résultats de la détection les plus récents. Cela permet d'éviter le transfert de données entre les deux mémoires qui peut être coûteux, mais nécessite que l'unité de contrôle connaisse laquelle des deux mémoires stocke les résultats de détections les plus anciens. On comprendra que la manière dont la mémoire est géré (et notamment en ce qui concerne l'écriture/lecture/effacement des données qui y sont stockées) peut dépendre du type de mémoire, et/ou de sa technologie, et/ou de l'unité de contrôle.

L'unité de contrôle peut également comporter une unité de calcul qui calcule la vitesse de déplacement et la direction de déplacement d'une source lumineuse détectée par comparaison des enregistrements de la première mémoire et de la deuxième mémoire. La comparaison des données stockées dans les deux mémoires permet à chaque nouveau cycle de détection des DEL de déterminer la nouvelle position des sources lumineuses précédemment détectées. Le nombre de sources lumineuses détectées peut être important; typiquement lorsque les éléments qui réfléchissent la lumière des phares du véhicule sont des gouttes de pluie (dans ce cas, chaque goutte de pluie est considéré étant comme une source lumineuse) des hypothèses représentatives d'un comportement des éléments réfléchissant (par exemple des gouttes de pluie) mesuré statistiquement peuvent être utilisées ; ces hypothèses permettent de déterminer quelle sont les plus probables positions des gouttes de pluie entre deux détections afin d'éliminer certains des déplacements qui pourraient être mesurés lors de la comparaison des données des deux mémoires.

Par exemple, la vitesse de déplacement des gouttes de pluie peut être calculée par la corrélation des deux images prises à deux moments différents avec des logiciels de corrélation d'images (corrélation croisée ou corrélation globale) utilisé par exemple dans la mesure de déformation de la matière (résistance des matériaux). Ici, le terme image signifie un enregistrement dans une des mémoires du résultat de la détection des DEL d'une matrice, ou alors des miroirs pour lesquels la DEL a détecté une source lumineuse lorsque ceux-ci étaient en position permettant de réfléchir la source lumineuse vers la DEL. Une image (stockée dans une des mémoires du projecteur) est une représentation d'une scène dans laquelle une ou plusieurs sources lumineuses de la scène détectées ont une représentation qui diffère du reste de la scène. Le document R. Cintrón, V. Saouma, « Strain Measurements with the Digital Image Correlation System Vic-2D », 2008, expose un exemple d'une méthode de corrélation appliquée à des mesures de déformation de tâche lors de la déformation de la matière sous contrainte. D'autres méthodes peuvent être utilisées, basées par exemple sur les algorithmes ILS (acronyme de l'anglais « iterative least squares algorithm », littéralement algorithme des moindres carrés itératif) ou encore PLS (acronyme de l'anglais « pointwise least squares algorithm », littéralement algorithme des moindres carrés ponctuel).

De plus, le calcul qui permet de déterminer la nouvelle position des sources lumineuses précédemment détectées peut prendre en compte des facteurs externes aux mesures faites par le projecteur. Ces facteurs externes peuvent être par exemple la vitesse de déplacement du véhicule (l'unité de contrôle peut être configurée pour recevoir en temps réel les informations concernant la vitesse du véhicule). Un autre exemple de facteur externe est les informations contenues dans un signal vidéo reçu par l'unité de contrôle ; une caméra embarquée sur un véhicule peut permettre de grouper les sources lumineuses détectées suivant un ou plusieurs critères tels que par exemple leur origine (goutte de pluie, phare d'un véhicule arrivant en face) dans le but d'appliquer à chaque groupe des hypothèses représentatives d'un comportement mesuré statistiquement différentes.

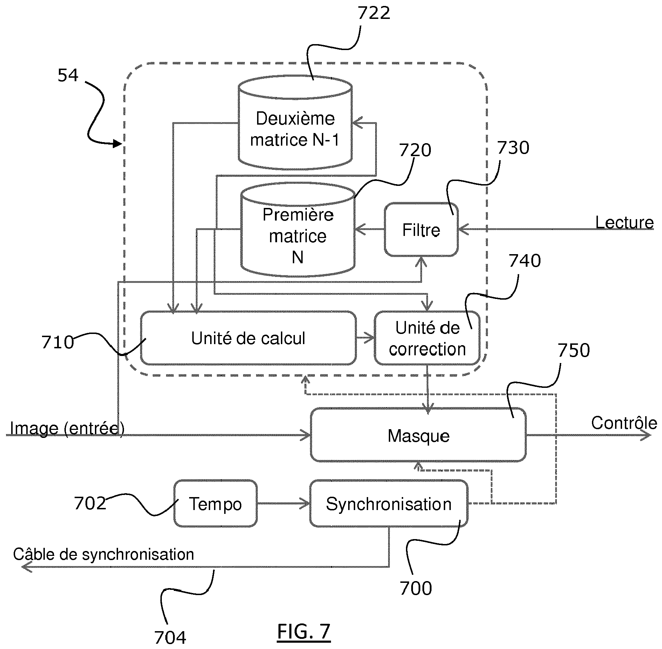

La figure 7 montre un exemple d'une unité de contrôle 54 d'un projecteur selon l'invention. Elle comprend une unité de synchronisation 700 permettant d'émettre un signal de synchronisation via par exemple le câble 704. L'unité de contrôle peut être associée à un temporisateur 702 permettant par exemple de commander que le calcul de la vitesse de déplacement et de la direction de déplacement d'une source lumineuse doit être réalisé, par exemple par l'unité de calcul 710 ; ou encore permettant de commander l'utilisation d'un masque sur le projecteur comme expliqué ci-dessous. L'unité de calcul 710 est également reliée à une première mémoire 720 sur laquelle sont enregistrés les nouveaux résultats de la détection notés N, et une deuxième mémoire sur laquelle sont enregistrés les précédents résultats de la détection notés *N-1*. Avant d'être enregistrés, les nouveaux résultats de la détection peuvent être filtrés par une unité de filtrage 730. Le filtrage peut par exemple comprendre la création de groupes de sources lumineuses en fonction de leur origine. L'unité de calcul peut être reliée en sortie à une unité de correction des calculs 740 qui est en charge d'appliquer aux résultats fournis par l'unité de calcul des corrections en fonction par exemple des facteurs externes discutés précédemment. En sortie de l'unité de calcul 710 ou de l'unité de correction des calculs 740 le cas échéant, une unité de calcul de masque 750 détermine quelles sont les DEL de la matrice ou bien quels sont les miroirs de la matrice qui pourront contribuer à éclairer la scène. Dans ce but, l'unité de calcul de masque calcul un masque pouvant être appliqué à la matrice de DEL ou à la matrice. Le masque permet de sélectionner, dans une matrice de DEL ou de miroirs, un sous-ensemble de DEL à activer pour émettre de la lumière ou de miroirs à positionner pour réfléchir la lumière émise par au moins une DEL, ou au contraire un sous-ensemble de DEL à désactiver ou de miroirs à positionner pour ne réfléchir pas la lumière émise par au moins une DEL. Le choix des DEL à activer ou miroirs à mettre dans une position déterminée est réalisé en fonction des données fournies par l'unité de calcul 710 ou de correction des calculs 740; le calcul du masque comprend l'application, à chaque source lumineuse dernièrement détectée (c'est-à-dire sur les enregistrements de la mémoire 720), de la vitesse de déplacement et de la direction de déplacement calculés par l'unité 710 ou 740 le cas échéant.

Ainsi, l'image stockée dans la deuxième mémoire est modifiée en fonction des prévisions de déplacement des sources lumineuses détectées, et cette image modifiée sert de masque permettant d'occlure une(des) espaces de la scène. Le masque sert à empêcher que la ou les DEL du projecteur ne viennent éclairer des zones de la scène comprenant des éléments susceptibles de réfléchir la lumière émise par le projecteur, et donc d'éblouir le conducteur du véhicule. Le masque est donc une grille dont chacune des cases est en correspondance avec une DEL de la matrice ou encore un miroir de la matrice. Les cases de cette grille correspondent aux futures positions calculées pour les éléments susceptibles de réfléchir la lumière émise par le projecteur, ces futures positions étant calculées pour une période d'allumage du projecteur prédéterminée, sont des cases pour lesquelles les DEL correspondantes ne seront pas allumées ou les miroirs correspondants ne seront pas positionnés pour réfléchir la lumière de la DEL lorsque le projecteur émettra de la lumière. En conséquent, ces éléments susceptibles de réfléchir la lumière ne réfléchiront pas la lumière émise par le projecteur.

Le masque peut en outre être calculé pour que des zones supplémentaires de la scène, autres que celles comprenant des éléments susceptibles de réfléchir lumière émise par le projecteur, soient elles aussi non éclairées. Par exemple, l'unité de calcul de masque 750 peut être connectée à une source vidéo (par exemple une caméra) via une interface vidéo spécialisée discutée précédemment. L'unité de calcul de masque interprète les informations vidéos reçues et détermine les zones de la scène à ne pas éclairer. Des moyens et des algorithmes connus peuvent être utilisés à cette fin. Par exemple, une méthode simple peut consister à réaliser une addition entre le masque calculé et l'image fournie par la source vidéo.

La Figure 4 décrit un exemple d'un dispositif d'éclairage d'une scène qui comprend deux projecteurs selon l'exemple de la Figure 3a. Dans cet exemple, les projecteurs sont des phares avant d'une voiture qui détectent les vitesses de déplacements et les directions de déplacement de gouttes de pluies, et modifient leur éclairage en fonction du résultat de la détection afin de diminuer la réflexion des phares de la voiture sur les gouttes de pluies. Le dispositif peut également être appliqué à des phares situé à l'arrière du véhicule afin d'optimiser la prise de vue d'une caméra arrière par exemple. Chacun des deux projecteurs comprend une unité de contrôle qui configure le fonctionnement des DEL de sa matrice et permet l'envoie et la réception d'un signal de synchronisation, une unité de calcul, ainsi que deux mémoires permettant d'enregistrer les résultats de sa détection. Le dispositif comporte un premier projecteur 402 qui est appelé projecteur maître car c'est l'unité de contrôle du projecteur 402 qui émet le signal de synchronisation indiquant au deuxième projecteur 404 s'il doit émettre de la lumière ou bien détecter des sources lumineuses. Le deuxième projecteur est appelé projecteur esclave car il ne change de fonctionnement qu'après avoir reçu le signal de synchronisation. Dans cet exemple, toutes les DEL de la matrice d'un projecteur adoptent le même fonctionnement. Ainsi, comme représenté sur le dispositif 40, lorsque toutes les DEL de la matrice du projecteur maître 402 fonctionnent comme détecteur, toutes les DEL de la matrice du projecteur esclave 404 émettent de la lumière. Inversement 42, après que le projecteur maître a transmis le signal de synchronisation, toutes les DEL du projecteur maître émettent de la lumière et toutes les DEL du projecteur esclave détectent les sources lumineuses (les gouttes de pluie qui réfléchissent la lumière émise par le projecteur maître et constituent des sources lumineuses). Les deux projecteurs sont reliés via un BUS sur lequel transitent les signaux de synchronisation, par exemple un câble électrique (ou fil) dédié à la synchronisation des deux projecteurs.

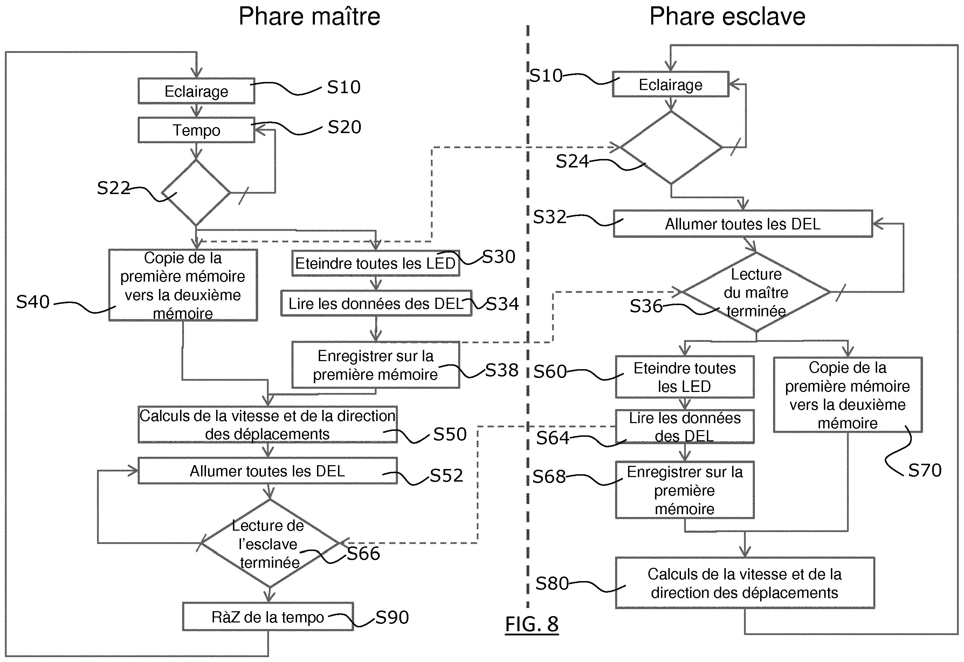

Un exemple de la coopération entre le projecteur maître et le projecteur esclave ainsi que le fonctionnement interne de chaque projecteur est maintenant décrits en référence au schéma d'opération de la Figure 8.

A l'étape S10, les deux projecteurs émettent de la lumière, typiquement une route et ses abords; ils jouent le rôle par exemple de phares de route ou de croisement. Dépendant du résultat d'une précédente détection, les matrices des deux projecteurs peuvent avoir deux configurations :
(i) Si la dernière détection n'a révélé aucune source lumineuse, les DEL de chaque projecteur émettent de la lumière et éclairent la scène. Alternativement, le nombre de DEL peut être réduit selon un schéma prédéterminé ; par exemple, les projecteurs fonctionnent comme feux de croisement qui ne doivent pas fournir la même puissance d'éclairage que ces mêmes projecteurs fonctionnant comme feux de route.
(ii) Si la dernière détection a révélé des sources lumineuses pour l'un et/ou l'autre projecteur, les DEL émettant de la lumière sur chaque projecteur sont sélectionnées grâce à un masque obtenu à partir d'un précèdent calcul des vitesses de déplacement et des directions de déplacement des sources lumineuses précédemment détectées.

L'étape S10 est déclenchée sur envoi d'un message de synchronisation du projecteur maître au projecteur esclave : une fois la synchronisation émise, le projecteur maître émet de la lumière et le projecteur esclave émet de la lumière dès la réception du signal. En pratique, le temps de transmission d'un signal de synchronisation est de quelques millisecondes, de sorte que le conducteur ne constate pas de décalage entre l'allumage des deux projecteurs.

A l'étape S20, un temporisateur (« timer » en anglais) est déclenché. Il peut être déclenché en même temps que l'émission du signal de synchronisation à l'étape S10. Le temporisateur sert à mesurer une quantité de temps qui s'écoule. Tant que la quantité de temps n'est pas écoulée, les deux projecteurs sont maintenus dans un mode d'éclairage, par exemple comme feux de route. Ce temps peut être prédéterminé ; par exemple, la durée mesurée peut être comprise entre 0.5 et 5 secondes, de préférence de l'ordre de la seconde. Ce temps peut être dynamiquement déterminé. Par exemple, si une précédente détection a révélé de très nombreuses gouttes de pluie comme sources lumineuses, cela signifie que la pluie est importante et qu'il est donc nécessaire de refaire les détections plus souvent.

Lorsque le temps est écoulé (S22), le projecteur maître envoie un signal de synchronisation au projecteur esclave. Ce signal est interprété par l'unité de contrôle du projecteur esclave comme un ordre (S24) d'allumer toutes les LED de sa matrice. L'unité de contrôle du projecteur esclave déclenche (S32) l'alimentation en courant électrique de l'ensemble de DEL qu'il gère.

Toujours suite au test S22, le projecteur maître réalise les deux opérations suivantes.

La première opération comprend trois sous-opérations successives qui sont : (i) faire fonctionner toutes ou une partie des DEL (S30) de la matrice du projecteur maître comme détecteurs de sources lumineuses ; plus aucune DEL du projecteur maître n'émet de lumière ; (ii) lire sur la matrice du projecteur maître (S34) par l'unité de contrôle du projecteur maître quelles sont les DEL qui ont détecté une source lumineuse ; (iii) envoyer un signal de synchronisation au projecteur esclave qui est interprété par unité de contrôle du projecteur esclave comme un ordre (S36) d'éteindre (S60) toutes les LED de la matrice du projecteur esclave : la détection de la matrice du projecteur maître est achevée.

La deuxième opération comprend la copie (S40) sur la deuxième mémoire des informations contenue dans la première mémoire. La deuxième mémoire stocke désormais les enregistrements de l'avant-dernier fonctionnement des DEL du projecteur maître.

En pratique, ces deux opérations commencent au même instant. Il peut être envisagé de les faire commencer avec un décalage dans le temps, ou bien encore de les réaliser l'une après l'autre. Il est préférable que la copie S40 soit réalisée le plus rapidement possible afin que le résultat de la lecture de l'étape S34 puisse être rapidement enregistré (S38) sur la première mémoire du projeteur maître.

A l'étape S50, l'unité de contrôle du projecteur maître calcule le masque comme discuté en référence à la Figure 7.

A l'étape S52, l'unité de contrôle du projecteur maître commande que toutes les LED de la matrice soient allumées et qu'elles le restent tant que le projecteur maître n'a pas reçu un signal de synchronisation émis par le projecteur esclave.

Suite à l'étape 36, c'est-à-dire après que le projecteur esclave a reçu le signal de synchronisation interprété par l'unité de contrôle du projecteur esclave comme un ordre (S36) d'éteindre toutes ses DEL, le projecteur esclave réalise les deux opérations suivantes.

La première opération comprend de cesser de faire fonctionner (S60) toutes ou une partie des DEL de la matrice du projecteur esclave qui n'émettent plus de lumière. Les DEL fonctionnent dès lors comme détecteurs de sources lumineuses.

La deuxième opération comprend la copie (S70) sur la deuxième mémoire du projecteur esclave des enregistrements contenus sur la première mémoire du projecteur esclave. La copie effectuée, la deuxième mémoire stocke donc les enregistrements de l'avant-dernier fonctionnement des DEL du projecteur esclave. Cette étape S70 est donc semblable à celle pratiquée par le projecteur maître à l'étape S40.

En pratique, ces deux opérations commencent au même instant. On peut les faire commencer avec un décalage dans le temps, ou bien encore de les réaliser l'une après l'autre. Il est préférable que la copie S70 soit réalisée le plus rapidement possible afin que le résultat de la lecture de l'étape S64 puisse être enregistré (S68) sur la première mémoire du projeteur esclave rapidement.

Ainsi, suite à l'arrêt de toutes les DEL, l'unité de contrôle sur projecteur esclave lit les DEL de la matrice qu'il contrôle et détermine (S64) quelles sont les DEL qui ont détecté une source lumineuse.

Les résultats lus par l'unité de contrôle sont enregistrés sur la première mémoire (68). Cette étape S68 est semblable à celle pratiquée par le projecteur maître à l'étape S38.

Ensuite, à l'étape S80, le projecteur esclave réalise un calcul de masque de la même manière que celui effectué précédemment à l'étape S50 par le projecteur maître.

La lecture de l'étape S64 terminée, le projecteur esclave envoie un signal de synchronisation au projecteur maître qui l'interprète comme signifiant que l'unité de contrôle du projecteur esclave a terminé la lecture des DEL de la matrice fonctionnant comme détecteurs.

Le cycle de détection est donc achevé, et un cycle d'éclairage de la route qui prend en compte les résultats de la détection est maintenant réalisé.

Le temporisateur activé à l'étape S20 est remis à zéro dès que l'étape S80 a été réalisée. Suite à la réinitialisation S90, les deux projecteurs émettent de la lumière et chaque projecteur applique le masque (S10) calculé respectivement aux étapes S50 et S80.

Lorsque le temps mesuré par le temporisateur est écoulé (S20, S22), une nouvelle phase de détection du procédé est répétée tant que les projecteurs du véhicule doivent éclairer la scène.

La détection des éléments de la scène réfléchissant la lumière émise par les projecteurs tels que des gouttes de pluie est ainsi réalisée localement par chaque projecteur, et l'exploitation des résultats de la détection est également réalisée localement par chaque projecteur. Il n'y a donc pas besoin de calculs supplémentaires qui auraient pour but de compenser une différence de localisation entre l'endroit où sont réalisés la détection et l'endroit où est situé le projecteur, contrairement au cas d'une solution qui utilise une seule caméra qui n'est pas située au niveau des projecteurs. De plus, l'ensemble des opérations qui nécessitent un calcul ainsi que la préparation des données nécessaires à la réalisation de ces calculs sont réalisées par et pour chaque projecteur : il n'y a donc pas de temps de latence introduit par exemple par un transfert de données, ou tout du moins les temps de latence sont réduits à des transfert locaux au niveau du projecteur. Les seuls transferts de données extérieurs au projecteur sont les envois de messages de synchronisation qui ne comportent aucune difficulté techniques de mise en oeuvre ; le transfert de messages de synchronisation est également extrêmement rapide et peut même être assorti de contraintes temporelles de type temps réel permettant d'assurer un fonctionnement extrêmement rapide du dispositif selon l'invention, notamment pour ce qui concerne la détection. En outre, une même matrice de DEL peut tour à tour servir de composant de détection et de composant d'éclairage : la diminution du nombre de composants facilite l'intégration des fonctions nécessaires à la détection, ainsi que la fiabilité du projecteur et du dispositif selon l'invention.

La Figure 4 montre un exemple de la chronologie des étapes du procédé tel qu'il peut être exécuté par le dispositif selon l'invention. On peut noter qu'une ou plusieurs étapes du procédé sont regroupées afin d'être exécutée durant une période prédéterminée. Par exemple sur la figure 4, la lecture des données et le calcul du masque sont réalisés pendant une période de durée d'environ 10ms, étant entendu que la durée des périodes varient en fonction de critères tels (mais pas limités à) la taille de la matrice, la puissance de calcul de l'unité de calcul,... De manière intéressante, chaque étape du procédé selon l'invention appartient à une des séquences de sorte que l'exécution du procédé est réalisée durant un temps prédéterminé. Le fonctionnement du dispositif selon l'invention peut donc répondre à des contraintes temporelles de type temps réel. L'éclairage de la route n'est donc pas affecté par la détection et la sécurité du véhicule n'est pas compromise.

Des variantes du procédé décrit peuvent être implémentées. Par exemple, plutôt que le projecteur esclave envoie un signal de synchronisation au projecteur maître l'étape S64 terminée, le projecteur maître peut envoyer à l'étape S66 un signal de synchronisation au projecteur esclave afin de lui signifier que la lecture des DEL de sa matrice doit être réalisée. Dans ce cas, le projecteur maître peut comprendre un temporisateur qui mesure le temps écoulé depuis le moment où le projecteur maître a envoyé le signal de synchronisation après l'étape S34 afin de laisser suffisamment de temps au projecteur esclave pour détecter des sources lumineuses. Dans cette variante, seul le projecteur gère le déclenchement des différentes étapes.

Lorsque les projecteurs réalisent leur première détection, typiquement quand l'allumage des phares d'une voiture a été demandé pour la première fois, les deux mémoires ne contiennent aucune information. Il est nécessaire pour effectuer les calculs des étapes S50 et S80 que les deux mémoires stockent des résultats d'une détection. Deux détections (S22 à S80) peuvent être consécutivement réalisées afin que les deux mémoires soient chargées par les mesures de détections réalisées par les LED. Le temps d'une détection est de l'ordre de quelques dizaines de millisecondes, de sorte que le conducteur ne constate pas de décalage entre l'ordre d'allumage des projecteurs et l'allumage effectif des projecteurs.

Les Figures 4 et 8 ont été décrites avec des projecteurs selon l'exemple de la Figure 3a. On comprendra que les exemples des Figures 3b et 3c ne modifient pas la manière dont la coopération entre le projecteur maître et le projecteur esclave a été décrite. En effet, la différence entre les Figures 3a, 3b et 3c est la manière dont on émet et reçoit de la lumière, directement avec la Figure 3a, et indirectement avec les Figures 3b et 3c. Ainsi la manière de commander les sources lumineuse émises par le projecteur (provenant soit directement des DEL de la matrice, soit réfléchies par les miroirs) diffère. L'exemple de la Figure 3b est un mode « mixte » comprenant une matrice de DEL et une matrice de miroir. On comprend que l'on peut utiliser à la fois la position des miroirs et la liste des diodes ayant détecté une source lumineuse pour calculer le masque, de même que la manière d'appliquer le masque.

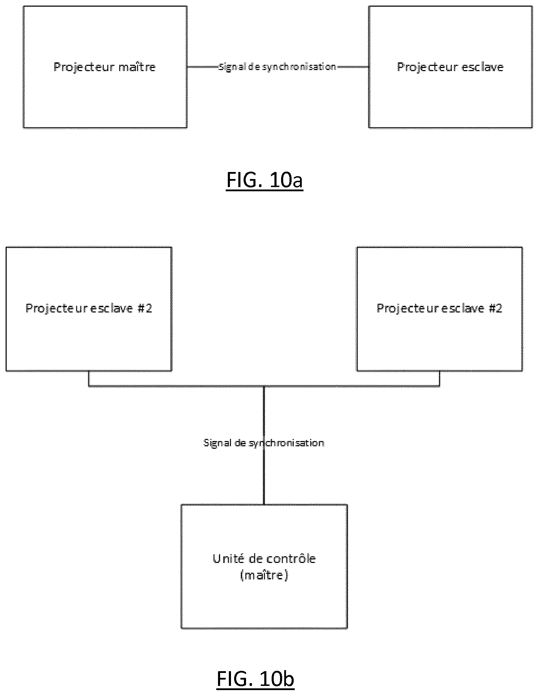

Dans les exemples ci-dessus, la synchronisation entre les deux projecteurs est dirigée par le projecteur dit « maitre », c'est-à-dire que les signaux de synchronisation sont envoyés par le projecteur maitre au projecteur esclave, comme représenté par le schéma de la Figure 10a. En pratique, les deux projecteurs comprennent l'unité de calcul. Dans un autre exemple, la synchronisation entre les deux projecteurs est contrôlée par une unité de contrôle couplée aux deux projecteurs, c'est-à-dire qu'il y a une unité de contrôle qui est commune aux deux projecteurs, comme représenté par le schéma de la figure 10b. Dans ce cas, les deux projecteurs fonctionnent comme des esclaves. On notera que dans ce dernier cas que certains des éléments qui peuvent être compris dans une unité de contrôle propre à chaque projecteur ne sont pas implémentés sur une unité de contrôle commune aux deux projecteurs. En particulier, chaque projecteur conserve ses premières et deuxièmes mémoires et son unité de calcul, de sorte que l'unité de contrôle peut ne servir qu'à envoyer les signaux de synchronisation et peut comprendre un ou plusieurs timer afin de déterminer quand envoyer les signaux de synchronisation. Ceci permet que les données captées par chaque projecteur ne doivent pas transiter sur un réseau, ce qui permet de réaliser les calculs plus rapidement.

## Revendications

1. Projecteur pour véhicule comprenant au moins une diode électroluminescente (30a, 30b, 30c), dans lequel ladite au moins une diode électroluminescente est configurée pour fonctionner comme un détecteur d'une source lumineuse.

2. Projecteur selon la revendication 1, adapté pour être couplé à une unité de contrôle (54) qui est configurée pour faire fonctionner alternativement ladite au moins une au moins une diode électroluminescente comme un détecteur d'une source lumineuse et comme un émetteur de lumière.

3. Projecteur selon la revendication 2, dans lequel l'unité de contrôle (54) est en outre configurée pour transmettre un signal de synchronisation (700, 704) indiquant si ladite au moins une diode électroluminescente fonctionne comme un émetteur de lumière ou comme un détecteur d'une source lumineuse.

4. Projecteur selon la revendication 3, dans lequel l'unité de contrôle est en outre configurée pour alterner le fonctionnement de ladite au moins une diode électroluminescente sur réception du signal de synchronisation.

5. Projecteur selon l'une des revendications 1 à 4, comprenant en outre :
- une première mémoire (720) qui enregistre si ladite au moins une diode électroluminescente a détecté une source lumineuse lors du dernier fonctionnement de ladite au moins une diode électroluminescente comme un détecteur d'une source lumineuse ; et
- une deuxième mémoire (722) qui enregistre si ladite au moins une diode électroluminescente a détecté une source lumineuse lors de l'avant-dernier fonctionnement de ladite au moins une diode électroluminescente comme un détecteur d'une source lumineuse.

6. Projecteur selon la revendication 5, comprenant en outre une unité de calcul (710) qui calcule la vitesse de déplacement et la direction du déplacement d'une source lumineuse détectée par comparaison des enregistrements de la première mémoire et de la deuxième mémoire.

7. Projecteur selon l'une des revendications 1 à 6, dans lequel une matrice de diode comprend ladite au moins une diode électroluminescente.

8. Projecteur selon la revendication 7, dans lequel une matrice de miroirs réfléchit une source lumineuse émise ou détectée par ladite au moins une diode électroluminescente de la matrice.

9. Projecteur selon l'une des revendications 7 ou 8, dans lequel toutes les diodes de la matrice fonctionnent alternativement comme des émetteurs de lumière et comme des détecteurs d'une ou plusieurs sources lumineuses.

10. Projecteur selon l'une des revendications 1 à 6, dans lequel une matrice de miroirs réfléchit une source lumineuse émise ou détectée par ladite au moins une diode électroluminescente, les miroirs de la matrice étant configurés pour qu'un seul miroir puisse réfléchir vers la ladite au moins une diode électroluminescente une source lumineuse.

11. Dispositif d'éclairage (40, 42) comprenant au moins deux projecteurs selon l'une des revendications 1 à 10.

12. Dispositif selon la revendication 11, dans lequel chaque projecteur comprend une unité de contrôle selon la revendication 4, les unités de contrôle étant connectées (704) entre elles afin que le signal de synchronisation transmis par l'unité de contrôle d'un des projecteurs soit reçu par l'unité de contrôle de l'autre projecteur.

13. Dispositif selon la revendication 11, dans lequel lesdits au moins deux projecteurs sont couplés à une unité de contrôle selon la revendication 3 ou 4 qui transmet le signal de synchronisation aux projecteurs.

14. Dispositif selon l'une des revendications 11 à 13, dans lequel chaque projecteur comprend une unité de calcul selon la revendication 6.

15. Dispositif selon l'une des revendications 11 à 14, dans lequel lesdits au moins deux projecteurs sont en outre configurés pour simultanément émettre de la lumière.

16. Procédé de détection et d'occlusion de sources lumineuses avec le dispositif selon la revendication 14, comprenant les étapes consistant à :
- envoyer un premier signal (S24) de synchronisation ;
- suite à l'envoi du premier signal de synchronisation :
-- émettre de la lumière avec ladite au moins une diode du deuxième projecteur (S32) ; et
-- faire fonctionner ladite au moins une diode du premier projecteur comme détecteur (S30, S34) d'une source lumineuse;
- enregistrer (S38) dans la première mémoire du premier projecteur si ladite au moins une diode du premier projecteur a détecté une source lumineuse ;
- envoyer un deuxième signal (S36) de synchronisation ;
- suite à l'envoi du deuxième signal de synchronisation :
-- émettre de la lumière avec ladite au moins une diode du premier projecteur (S52) ; et
-- faire fonctionner ladite au moins une diode du deuxième projecteur comme détecteur d'une source lumineuse;
- enregistrer dans la première mémoire du deuxième projecteur (S68) si ladite au moins une diode du deuxième projecteur a détecté une source lumineuse.

17. Procédé selon la revendication 16, comprenant en outre :
- répéter les étapes du procédé selon la revendication 16 dans lesquelles les étapes d'enregistrement sont réalisées sur la deuxième mémoire du premier ou deuxième projecteur ; et
- suite à l'enregistrement dans la deuxième mémoire du premier projecteur, calculer par l'unité de calcul la vitesse et la direction de déplacement de la source lumineuse (S50) détectée par le premier projecteur et déterminer les diodes de la matrice du premier projecteur pouvant émettre de la lumière en fonction du calcul ;
- suite à l'enregistrement dans la deuxième mémoire du deuxième projecteur, calculer par l'unité de calcul la vitesse et la direction de déplacement de la source lumineuse (S70) détectée par le deuxième projecteur et déterminer les diodes de la matrice du deuxième projecteur pouvant émettre de la lumière en fonction du calcul ;
- envoyer un troisième signal de synchronisation (S90);
- suite à l'envoi du troisième signal de synchronisation, configurer le premier et le deuxième projecteur pour qu'ils émettent simultanément de la lumière, seules étant activées les diodes déterminées comme pouvant émettre de la lumière.
